Europäisches Patentamt

(19) **European Patent Office**

**Office européen des brevets**

(11) Numéro de publication: **0 037 317**
**B1**

(12) **FASCICULE DE BREVET EUROPEEN**

(45) Date de publication du fascicule du brevet:
**30.05.84**

(51) Int. Cl.³: **H 03 D 1/00**, H 04 N 9/38

(21) Numéro de dépôt: **81400443.8**

(22) Date de dépôt: **20.03.81**

(54) **Procédé de démodulation d'un signal modulé en amplitude, démodulateur mettant en oeuvre ce procédé, et système de télévision comportant un tel démodulateur.**

(30) Priorité: **01.04.80 FR 8007297**

(43) Date de publication de la demande:
**07.10.81 Bulletin 81/40**

(45) Mention de la délivrance du brevet:
**30.05.84 Bulletin 84/22**

(84) Etats contractants désignés:
**AT BE CH DE GB IT LI LU NL SE**

(56) Documents cités:
**FR - A - 1 585 253**
**US - A - 3 952 187**
**US - A - 4 090 145**

(73) Titulaire: **THOMSON-CSF, 173, Boulevard Haussmann, F-75379 Paris Cedex 08 (FR)**

(72) Inventeur: **Marguinaud, André, THOMSON-CSF SCPI 173, bld Haussmann, F-75360 Paris Cedex 08 (FR)**
Inventeur: **Sorton, Gérard, THOMSON-CSF SCPI 173, bld Haussmann, F-75360 Paris Cedex 08 (FR)**

(74) Mandataire: **Turlèque, Clotilde et al, THOMSON-CSF SCPI 173, Bld Haussmann, F-75379 Paris Cedex 08 (FR)**

## Description

La présente invention concerne les procédés de démodulation d'un signal modulé en amplitude, résultant d'une modulation en amplitude, à porteuse supprimée, de deux porteuses en quadrature de phase, les démodulateurs mettant en oeuvre ces procédés et les systèmes de télévision PAL (Phase Alternation Line) et N.T.S.C. (National Television System Comittee) comportant de tels démodulateurs.

Les signaux vidéofréquences PAL et N.T.S.C. comprennent chacun: un signal de luminance, principalement situé dans la partie basse du spectre du signal vidéofréquence, et un signal de chrominance composé de deux modulations d'amplitude de deux sous-porteuses de même fréquence F mais déphasées de 90° l'une par rapport à l'autre.

Il est actuellement connu divers systèmes permettant la démodulation d'un tel signal de chrominance à l'aide de circuits démodulateurs analogiques classiques. D'autre part il est connu, par le brevet US 4 090 145 des dispositifs numériques permettant de déterminer la valeur de l'amplitude instantanée et de la phase instantanée d'un signal modulé en amplitude. Ces derniers dispositifs ne fournissent pas les amplitudes des deux composantes d'un signal de chrominance, mais seulement son amplitude globale.

Le procédé selon l'invention permet de déterminer la valeur de ces deux composantes et présente l'intérêt de pouvoir être mis en oeuvre à l'aide de circuits numériques simples.

Un procédé de démodulation selon l'invention, tel qu'il est décrit dans la revendication 1 ci-jointe, permet d'atteindre ce but.

Selon l'invention, il est également prévu un démodulateur pour mettre en oeuvre ce procédé, et un système de télévision comportant un tel démodulateur.

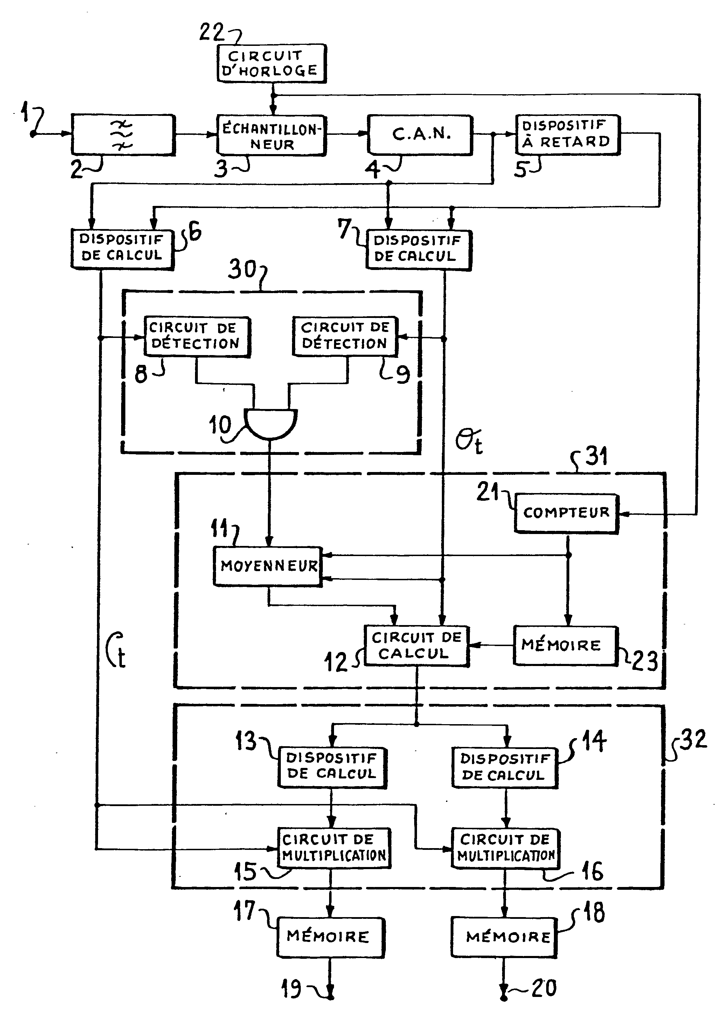

L'invention sera mieux comprise et d'autres caractéristiques apparaîtront à l'aide de la description ci-après et de la figure unique s'y rapportant sur laquelle est représenté un mode de réalisation d'un démodulateur selon l'invention.

En vue de rendre le dessin plus clair et de simplifier l'exposé, les dispositifs de synchronisation précise, relevant de la technologie courante, n'ont pas été représentés.

Sur la figure, une borne d'entrée 1 destinée à recevoir un signal vidéofréquence PAL est couplée à un échantillonneur 3 à travers un filtre passe-bande 2. Une entrée de commande de l'échantillonneur 3 est reliée à la sortie d'un circuit d'horloge 22 et à l'entrée d'un compteur 21. La sortie de l'échantillonneur 3 est couplée à l'entrée d'un dispositif à retard 5 à travers un convertisseur analogique-numérique 4. L'entrée du dispositif à retard 5 est en outre connectée à une première entrée d'un dispositif de calcul 6 et à une première entrée d'un dispositif de calcul 7. La sortie du dispositif à retard 5 est connectée à une seconde entrée du dispositif de calcul 6 et à une seconde entrée du dispositif de calcul 7. La sortie du dispositif de calcul 6 est couplée à une première entrée d'une porte ET, 10, à travers un circuit de détection 8, à une première entrée d'un circuit de multiplication 15, et à une première entrée d'un circuit de multiplication 16. La deuxième entrée et la sortie de la porte ET, 10, sont respectivement couplées à la sortie du dispositif de calcul 7 à travers un circuit de détection 9 et à une entrée de commande d'un moyenneur 11. La sortie du dispositif de calcul 7 est en outre reliée à l'entrée du moyenneur 11 et à une première entrée d'un circuit de calcul 12 dont une deuxième entrée est reliée à la sortie du moyenneur 11. Une troisième entrée du circuit de calcul 12 est couplée à la sortie du compteur 21 à travers une mémoire 23. La sortie du compteur 21 est en outre connectée à une entrée de validation du moyenneur 11.

La sortie du circuit de calcul est couplée à une seconde entrée du circuit de multiplication 15 à travers un dispositif de calcul 13 et à une seconde entrée du circuit de multiplication 16 à travers un dispositif de calcul 14. La sortie du circuit de multiplication 15 est couplée à une borne de sortie 19 à travers une mémoire 17. La sortie du circuit de multiplication 16 est couplée à une borne de sortie 20 à travers une mémoire 18.

Les dispositifs de calcul 6 et 7 forment des premiers moyens de calcul pour déterminer les coordonnées polaires $(\rho_t, \theta_t)$ du vecteur tournant représentatif du signal présent sur la borne d'entrée 1.

Les circuits de détection 8 et 9, et la porte ET, 10, constituent des moyens de détection 30 pour détecter la présence de la salve de référence.

Le compteur 21, le moyenneur 11, la mémoire 23 et le circuit de calcul 12 forment un dispositif de calcul 31 pour calculer une valeur particulière $\gamma$.

Les dispositifs de calcul 13 et 14 et les circuits de multiplication 15 et 16 constituent un dispositif de calcul 32 pour calculer les valeurs $\alpha$ et $\beta$ des amplitudes des signaux de modulation en fonction de $\rho_t$ et de $\gamma$.

Et enfin, les dispositifs de calcul 31 et 32 constituent des deuxièmes moyens de calcul pour calculer les valeurs $\alpha$ et $\beta$ en fonction des coordonnées polaires du vecteur tournant représentatif du signal à démoduler et des instants auxquels le signal est échantillonné.

L'exemple de réalisation qui vient d'être décrit permet de démoduler le signal de chrominance d'un signal vidéofréquence PAL. Ce signal de chrominance, dont le spectre de fréquences s'étend de 3,1 MHz à 5,5 MHz, résulte d'une modulation en amplitude de deux sous-porteuses de même fréquence F égale à 4,4 MHz mais déphasées l'une par rapport à l'autre de 90°.

Comme tous les signaux de télévision, le signal de télévision PAL est constitué d'un signal de luminance, d'un signal de chrominance, d'un signal de synchronisation de trame et d'un signal de synchronisation de ligne.

Outre ces signaux, le signal de synchronisation de ligne est accompagné d'un signal de synchronisation couleur, dit encore salve de référence. Cette salve est constituée d'un train de signaux sinusoïdaux à la fréquence exacte F de la sous-porteuse de chrominance et d'amplitude constante.

Le fonctionnement de ce démodulateur numérique sera mieux compris à l'aide d'un développement théorique simple, dont il va être donné les principales étapes.

L'expression algébrique de l'amplitude instantanée $y(t)$ d'un signal de chrominance d'un signal vidéofréquence PAL est la suivante:

①  $y(t) = A(t) . \cos \omega t + B(t) . \sin \omega t$ avec $\omega = 2\pi F$.

Les termes $\cos \omega t$ et $\sin \omega t$ correspondent respectivement à la première sous-porteuse et à la seconde sous-porteuse de même pulsation $\omega$ et déphasées de 90° l'une par rapport à l'autre.

Les termes $A(t)$ et $B(t)$ correspondent aux signaux de modulation en amplitude des deux sous-porteuses.

L'expression algébrique de l'amplitude instantanée $x(t)$ de la salve de référence est la suivante:

$$x(t) = C \cos (\omega t + \varphi_0)$$

Dans cette expression, $C$ représente une constante, $\varphi_0$ correspond au déphasage entre la salve de référence et la première sous-porteuse. La valeur de $\varphi_0$ est de 135°.

Pendant une période égale à $\frac{1}{F}$, les variations des signaux de modulation sont suffisamment faibles pour que l'on puisse considérer les termes $A(t)$ et $B(t)$ comme constants.

Sur une période de la sous-porteuse, il est donc supposé:

$$\begin{cases} A(t) = \alpha \\ B(t) = \beta \end{cases}$$

$\alpha$ et $\beta$ correspondant à des constantes.

L'expression algébrique ① devient alors:

$$y = \alpha \cos \omega t + \beta \sin \omega t. \quad ②$$

La démodulation d'un signal dont l'amplitude est donnée par l'expression ② revient à déterminer les valeurs de $\alpha$ et de $\beta$.

Considérons les valeurs $y(t - \frac{1}{4F})$ et $y(t)$ de l'amplitude du signal de chrominance aux instants $t - \frac{1}{4F}$ et $t$.

Les expressions de $y(t - \frac{1}{4F})$ et de $y(t)$ sont les suivantes:

$$\begin{cases} y(t - \frac{1}{4F}) = \alpha \cos (\omega t - \frac{\pi}{2}) + \beta \sin (\omega t - \frac{\pi}{2}) \\ = \sqrt{\alpha^2 + \beta^2} \cos (-\omega t + \text{arc tg} \frac{\beta}{\alpha} + \frac{\pi}{2}) \\ y(t) = \alpha \cos (\omega t) + \beta \sin (\omega t) \\ = \sqrt{\alpha^2 + \beta^2} \sin (-\omega t + \text{arc tg} \frac{\beta}{\alpha} + \frac{\pi}{2}) \end{cases}$$

De même, les valeurs $x(t - \frac{1}{4F})$ et $x(t)$ de l'amplitude de la salve de référence aux instants $t - \frac{1}{4F}$ et $t$ ont pour expression:

$$\begin{cases} x(t - \frac{1}{4F}) = C \cos (-\omega t - \varphi_0 + \frac{\pi}{2}) \\ x(t) \quad\quad = C \sin (-\omega t - \varphi_0 + \frac{\pi}{2}) \end{cases}$$

Considérons le cercle trigonométrique classique, d'axes orthogonaux OX et OY et les vecteurs $\overrightarrow{OM_t}$ et $\overrightarrow{OS_t}$ de composantes respectives

$[y(t - \frac{1}{4F}), y(t)]$ et $[x(t - \frac{1}{4F}), x(t)]$ dans le repère OXY.

Les coordonnées polaires $(\rho_t, \theta_t)$ du vecteur $\overrightarrow{OM_t}$ et les coordonnées polaires $(\mu_t, \psi_t)$ du vecteur $\overrightarrow{OS_t}$ ont pour expression:

$$\begin{cases} \rho_t = \sqrt{y^2(t - \frac{1}{4F}) + y^2(t)} = \sqrt{\alpha^2 + \beta^2} \quad ③ \\ \theta_t = \text{arctg} \dfrac{y(t)}{y(t - \frac{1}{4F})} = -\omega t + \text{arctg} \frac{\beta}{\alpha} + \frac{\pi}{2} \quad ④ \end{cases}$$

$$\begin{cases} \mu_t = \sqrt{x^2(t - \frac{1}{4F}) + x^2(t)} = C \quad ⑤ \\ \psi_t = \text{arctg} \dfrac{x(t)}{x(t - \frac{1}{4F})} = -\omega t - \varphi_0 + \frac{\pi}{2} \quad ⑥ \end{cases}$$

La formule ④ ne permet pas de déduire directement $\text{arctg} \frac{\beta}{\alpha}$ à partir des valeurs de $y(t)$ et de $y(t - \frac{1}{4F})$. En effet, le terme $t$ dépend de l'instant initial d'échantillonnage $t_0$.

L'élimination de ce terme s'effectue simplement en combinant les équations ④ et ② .

D'où le système d'équations suivant:

$$\begin{cases} \sqrt{\alpha^2 + \beta^2} = \rho_t \\ \text{arctg} \frac{\beta}{\alpha} = \theta_t - \psi_t - \varphi_0 = \gamma \quad ⑦ \end{cases}$$

Les valeurs de $\alpha$ et de $\beta$ sont alors données par les expressions suivantes:

$$\begin{cases} \alpha = \rho_t \cos \gamma \quad ⑧ \\ \beta = \rho_t \sin \gamma \quad ⑨ \end{cases}$$

Comme la fréquence et l'amplitude de la salve de référence sont fixes, il est à noter qu'à tous les instants $t_2 + \frac{n}{F}$ ($n$ entier positif, $t_2$ instant quelconque), $\psi_t$ prend une valeur identique $\psi_{t2}$; qu'aux instants $t_2 + \frac{n}{F} + \frac{1}{4F}$, $\psi_t$ prend une valeur $\psi_{t2} - \frac{\pi}{2}$; qu'aux instants $t_2 + \frac{n}{F} + \frac{2}{4F}$, $\psi_t$ prend la valeur $\psi_{t2} - \pi$; et qu'aux instants $t_2 + \frac{n}{F} + \frac{3}{4F}$, $\varphi_t$ prend la valeur $\psi_{t2} - \frac{3}{2}\pi$ .

Ainsi pour les instants $t_0 + \frac{n}{F} + \frac{P}{F}$, la formule ⑦ peut être remplacée par la formule ⑩ suivante ($P$ pouvant prendre soit la valeur 0, soit 1, soit 2, soit 3):

$$\text{arctg} \frac{\beta}{\alpha} = \theta_{t2} + \frac{n}{F} + \frac{P}{F} - \psi_{t2} + P\frac{\pi}{2} - \varphi_0 = \gamma \quad ⑩ .$$

En pratique, le procédé de démodulation d'un signal de chrominance PAL, selon l'invention, consiste à échantillonner la salve de référence et le signal de chrominance à un rythme égal à 4 fois la fréquence F de la sous-porteuse, à stocker chaque échantillon pendant la durée $\frac{1}{4F}$, à calculer à chaque instant d'échantillonnage t les coordonnées polaires du vecteur ayant pour composantes: soit $[x(t), x(t - \frac{1}{4F})]$ pour la salve de référence (formules ⑤ et ⑥ ), soit $[y(t), y(t - \frac{1}{4F})]$ pour le signal de chrominance (formules ③ et ④ ), à déterminer à chaque instant d'échantillonnage la valeur de $\gamma$ d'après la formule ⑦ , et à calculer ensuite les valeurs de $\alpha$ et de $\beta$ d'après les équations ⑧ et ⑨ .

En ce qui concerne les valeurs $\psi_t$ de l'angle polaire du vecteur associé à la salve de référence, il suffit de calculer sa valeur $\psi_{t_0}$ aux instants $t_0 + \frac{n}{F}$ ($t_0$ correspondant à l'instant initial d'échantillonnage) et de déduire ses valeurs aux instants d'échantillonnage $t_0 + \frac{n}{F} + \frac{P}{4F}$ par rotation de $P\frac{\pi}{2}$: $\psi \ t_0 + \frac{n}{F} + \frac{P}{F} = \psi_{t_0} - P\frac{n}{2}$, de sorte que la détermination de la valeur de $\gamma$ s'effectue à l'aide de la formule ⑩ en remplaçant $t_2$ par $t_0$.

Le fonctionnement du dispositif décrit sur la figure est le suivant:

Le signal vidéofréquence PAL reçu sur la borne d'entrée 1 est filtré par le filtre 2 pour sélectionner uniquement le signal de chrominance. Ce filtre est un passe-bande 3,1 MHz - 5,5 MHz, ce qui correspond au spectre de fréquence du signal de chrominance. Le signal obtenu à la sortie du filtre 2 est échantillonné, à partir de l'instant initial $t_0$, par l'échantillonneur 3 suivant la fréquence d'échantillonnage 4F délivrée par le circuit d'horloge 22. Les échantillons sont ensuite convertis en signaux binaires par le convertisseur analogique numérique 4.

Le dispositif à retard 5 retarde les échantillons délivrés par le convertisseur 4 d'une durée $\tau = \frac{1}{4F}$. A un instant d'échantillonnage quelconque $t_1$, les dispositifs de calcul 6 et 7 reçoivent sur leurs entrées la valeur numérique d'un échantillon de signal $V(t_1)$ et la valeur numérique d'un échantillon de signal $V(t_1 - \frac{1}{4F})$ délivré par le dispositif à retard 5.

Le dispositif de calcul 6 permet de calculer le module du vecteur $z(t_1)$ de coordonnées $[V(t_1), V(t_1 - \frac{1}{4F})]$ dans le repère OXY.

Le dispositif de calcul 7 permet de calculer l'angle polaire de ce vecteur $z(t_1)$.

Le signal présent à la sortie du filtre 2 correspond soit à la salve de référence, soit au signal de chrominance. La détermination des valeurs $\alpha$ et $\beta$ correspondant aux deux signaux de modulation en amplitude s'effectue à l'aide des formules théoriques ⑧ et ⑨ .

L'application de ces formules nécessite le calcul des coordonnées polaires des vecteurs associés au signal de chrominance, ainsi que le calcul de l'angle polaire des vecteurs associés à la salve de référence

aux instants $t_0 + \frac{n}{F}$. Pour cela, les moyens de détection 30 détectent la salve de référence et délivrent un signal de commande pendant toute la durée de la détection. Cette détection se fait à l'aide des deux circuits de détection 8 et 9.

Le circuit 8 fournit un premier signal de commande lorsque la valeur d'amplitude calculée par le dispositif de calcul 6 est identique à une valeur d'amplitude théorique de la salve de référence. Le circuit 9 compare les valeurs d'angle délivrées par le dispositif de calcul 7 à des instants espacés d'une période $\frac{1}{F}$.

Lorsque sur plusieurs comparaisons successives, l'écart des valeurs reste inférieur à un seuil fixé, le circuit 9 fournit un deuxième signal de commande. Les premier et deuxième signaux de commande permettent de débloquer la porte ET, 10, qui fournit le signal de commande indiquant la présence de la salve.

A partir de l'instant initial d'échantillonnage $t_0$, le compteur 21, inclus dans le dispositif de calcul 31, délivre un nombre I de valeur 00 aux instants $t_0 + \frac{n}{F}$, de valeur 01 aux instants $t_0 + \frac{n}{F} + \frac{1}{4F}$, de valeur 10 aux instants $t_0 + \frac{n}{F} + \frac{1}{4F}$, et de valeur 11 aux instants $t_0 + \frac{n}{F} + \frac{3}{4F}$.

Le moyenneur 11 effectue une moyenne, sur cinq périodes de durée $\frac{1}{F}$, des valeurs d'angle délivrées par le dispositif de calcul 7 lorsque la salve de référence à été détectée par les moyens de détection 30. Le moyenneur 11 ne prend en compte que les valeurs d'angle calculées aux instants $t_0 + \frac{n}{F}$, c'est-à-dire chaque fois que le compteur 21 fournit à l'entrée de validation du moyenneur 11 un nombre binaire dont la valeur est 00. Ces valeurs correspondent à la valeur $\psi_{t_0}$.

A la fin de la salve de référence, le moyenneur 11 fournit au circuit de calcul 12 une valeur estimée de l'angle polaire $\psi_{t_0}$ des vecteurs associés à la salve aux instants $t_0 + \frac{n}{F}$.

La mémoire 23 comporte quatre cases de mémoire mémorisant respectivement les valeurs $135°, \frac{\pi}{2} - 135°, \pi - 135°$, et $\frac{3\pi}{2} - 135°$.

A partir de l'instant initial $t_0$, le compteur 21 permet la lecture des valeurs mémorisées dans la mémoire 23 de façon que la sortie de cette mémoire 23 délivre la valeur $- 135°$ aux instants $t_0 + \frac{n}{F}$, la valeur $\frac{\pi}{2} - 135°$ aux instants $t_0 + \frac{n}{F} + \frac{1}{4F}$, la valeur $\pi - 135°$ aux instants $t_0 + \frac{n}{F} + \frac{2}{4F}$, et la valeur $\frac{3\pi}{2} - 135°$ aux instants $t_0 + \frac{n}{F} + \frac{3}{4F}$. Ces valeurs sont fournies à la troisième entrée du circuit de calcul 12.

Ainsi, pour le signal de chrominance, le circuit de calcul 12 effectue le calcul, tous les $\frac{1}{4F}$, de la valeur de l'angle $\gamma$ d'après la formule ⑩.

Puis, les dispositifs de calcul 13 et 14 effectuent respectivement le calcul de la valeur de sin $\gamma$ et le calcul de la valeur de cos $\gamma$.

Enfin, les circuits de multiplication 15 et 16 effectuent le calcul des valeurs de $\alpha$ et de $\beta$ d'après les formules ⑧ et ⑨. Ces valeurs sont ensuite stockées dans les mémoires 17 et 18 puis délivrées sur les bornes de sortie 19 et 20.

L'invention n'est pas limitée au mode de réalisation décrit et représenté, de nombreuses variantes de réalisation sont possibles.

En particulier, les fonctions effectuées par le dispositif à retard 5, les dispositifs de calcul 6 et 7, les moyens de détection 30, le dispositif de calcul 31 et le dispositif de calcul 32 peuvent être réalisées à l'aide de dispositifs à transfert de charge (appelés D.T.C.), le convertisseur analogique numérique 4 étant alors supprimé.

Dans le mode de réalisation décrit, il a été choisi d'échantillonner le signal de chrominance à un rythme égal à 4 fois la fréquence F égale à 4,4 MHz. Mais la valeur du rythme d'échantillonnage peut être choisie égale à m fois la fréquence F (m réel positif). L'extrémité du vecteur tournant associé au signal se déplace alors sur une ellipse dont l'excentricité augmente avec l'écart de fréquence.

Il est aussi à remarquer que les positions respectives du filtre 2, de l'échantillonneur 3 et du convertisseur analogique numérique 4 peuvent être interverties.

Enfin, il est important de noter que l'invention est applicable à partir de tout signal résultant d'une modulation en amplitude, à porteuse supprimée, de deux porteuses à la même fréquence F et en quadrature de phase.

Notamment l'invention est applicable à un signal vidéofréquence N.T.S.C. en remplaçant dans le développement théorique la formule ② par la formule suivante:

$$y(t) = \alpha \cdot \cos(\omega t + \varphi_o) + \beta \cos(\omega t + \varphi_o + \frac{\pi}{2})$$

avec $\varphi_o$ égale à 33°, et en prenant comme expression de l'amplitude de la salve de référence l'équation suivante:

$$x(t) = C \cos(\omega t).$$

## Revendications

1. Procédé de démodulation d'un signal modulé en amplitude résultant d'une modulation en amplitude, à porteuse supprimée, d'une première et d'une deuxième porteuse à la même fréquence F et en quadrature de phase par deux signaux de modulation, le signal à démoduler étant représenté par la projection sur un axe OX d'un vecteur tournant autour d'un point O dans un repère OXY, ledit procédé consistant à échantillonner le signal à démoduler suivant la fréquence mF (m réel positif supérieur à 1), et à déter-miner les coordonnées polaires ($\rho_t$, $\theta_t$) du vecteur tournant au moyen de deux échantillons successifs du signal à démoduler, caractérisé en ce qu'il consiste en outre à déterminer les valeurs $\alpha$ et $\beta$ des amplitudes des deux signaux de modulation en fonction des coordonnées polaires du vecteur tournant et des instants auxquels le signal à démoduler est échantillonné.

2. Procédé de démodulation selon la revendication 1, le signal modulé étant précédé par un signal de référence à la fréquence F et d'amplitude donnée, caractérisé en ce qu'il consiste à déterminer l'angle polaire $\psi_t$ du vecteur représentatif du signal de référence et en ce que la détermination des valeurs des amplitudes des deux signaux de modulation est fonction des coordonnées polaires du vecteur tournant représentant le signal à démoduler et de la valeur $\psi_t$.

3. Démodulateur mettant en oeuvre le procédé selon la revendication 1, comportant: un échantillonneur (3) dont la fréquence d'échantillonnage est mF ayant une entrée pour recevoir le signal à démoduler; un convertisseur analogique-numérique (4) des échantillons sélectionnés par l'échantillonneur (3); un dispositif à retard (5) de retard $\tau$ égal à $\frac{1}{mF}$ ayant une entrée couplée à la sortie du convertisseur (4), caractérisé en ce qu'il comporte des premiers moyens de calcul (6 et 7) pour déterminer les coordonnées polaires ($\rho_t$, $\theta_t$) du vecteur tournant en fonction de deux échantillons successifs du signal, lesdits premiers moyens de calcul (6 et 7) ayant une première et une deuxième entrée respectivement couplées à l'entrée et à la sortie du dispositif à retard (5); et des deuxièmes moyens de calcul (31 et 32) pour déterminer les valeurs des amplitudes des deux signaux de modulation en fonction des coordonnées polaires du vecteur tournant et des instants auxquels le signal est échantillonné.

4. Démodulateur selon la revendication 3, caractérisé en ce que m est égal à 4, en ce que le convertisseur (4) et le dispositif à retard (5) fournissent respectivement à un instant t quelconque les échantillons Y(t) et Y(t $-\frac{1}{4F}$), et en ce que les premiers moyens de calcul (6 et 7) comportent un premier dispositif de calcul (6) pour calculer la valeur $\rho_t$ du module du vecteur tournant selon la formule

$$\rho_t = \sqrt{Y^2(t) + Y^2(t \frac{1}{4F})},$$

et un deuxième dispositif (7) de calcul pour calculer la valeur $\theta_t$ de la phase du vecteur tournant selon la formule:

$$\theta_t = \text{arc tg} \left( \frac{Y(t)}{Y(t - \frac{1}{4F})} \right)$$

5. Démodulateur selon la revendication 3, l'entrée de l'échantillonneur (3) recevant en outre un signal de référence de fréquence F et d'amplitude donnée, ce signal de référence précédant le signal à démoduler, ledit démodulateur mettant en oeuvre le procédé selon la revendication 2, caractérisé en ce qu'il comporte des moyens de détection (30) de la présence du signal de référence, et en ce que les deuxièmes moyens de calcul (31 et 32) comportent un premier dispositif de calcul (31) pour déterminer une valeur $\gamma$ selon la formule: $\gamma = \theta_t - \psi_t - \varphi_o$, $\varphi_o$ correspondant au déphasage du signal de référence avec la première porteuse, ce premier dispositif de calcul (31) ayant une entrée de commande couplée à la sortie des moyens de détection, et un deuxième dispositif de calcul (32) pour calculer $\alpha$ et $\beta$ selon les formules suivantes: $\alpha = \rho_t \cos \gamma$ et $\beta = \rho_t \sin \gamma$.

6. Démodulateur d'un signal modulé en amplitude, à porteuse supprimée, de deux porteuses à la même fréquence F et en quadrature de phase, caractérisé en ce qu'il comporte un échantillonneur du signal à démoduler couplé à des dispositifs à transfert de charge (D.T.C.) pour mettre en oeuvre l'un des procédés des revendications 1 et 2.

7. Système de télévision caractérisé en ce qu'il comporte au moins un démodulateur selon l'une des revendications 3 à 6.

## Claims

1. Method of demodulation of an amplitude modulated signal resulting from a suppressed carrier, amplitude modulation of first and second quadrature carriers of the same frequency F by two modulation signals, the signals to be demodulated being represented by the projection of a vector rotating about a point O within an OXY system onto an axis OX, said method consisting in sampling the signal to be demodulated at the frequency mF (m positive real number exceeding 1), and in determination of the polar coordinates $(\rho_t, \theta_t)$ of the rotating vector by means of two successive samples of the signal to be demodulated, characterized in that it further consists in determination of the values $\alpha$ and $\beta$ of the amplitudes of the two modulation signals depending on the polar coordinates of the rotating vector and on the moments where the signal to be demodulated is sampled.

2. Demodulation method according to claim 1, the modulated signal being preceded by a reference signal of the frequency F and of given amplitude, characterized in that it consists in determination of the polar angle $\psi_t$ of the vector representing the reference signal, and in that the determination of the amplitude values of the two modulation signals is a function of the polar coordinates of the rotating vector representing the signal to be demodulated and of the value $\psi_t$.

3. Demodulator performing the method according to claim 1, comprising: a sampler (3) the sampling frequency of which is mF and having an input for receiving the signal to be demodulated; an analog-digital converter (4) for converting the samples selected by the sampler (3); a delay device (5) with the delay $\tau = \dfrac{1}{mF}$ having an input coupled to the output of the converter (4), characterized in that it comprises first calculation means (6 and 7) for determination of the polar coordinates $(\rho_t, \theta_t)$ of the rotating vector as a function of two successive samples of the signal, said first calculation means (6 and 7) having first and second inputs coupled to the input and the output of the delay device (5), respectively; and second calculating means (31 and 32) for determination of the amplitude values of the two modulation signals as a function of the polar coordinates of the rotating vector and of the moments where the signal is sampled.

4. Demodulator according to claim 3, characterized in that m is equal to 4, that the converter (4) and the delay device (5) supply the samples Y (t) and $Y (t - \dfrac{1}{4F})$, respectively, at an arbitrary moment t, and in that the first calculation means (6 and 7) comprise a first calculation device (6) for calculating the value $\rho_t$ of the absolute value of the rotating vector from the formula

$$\rho_t = \sqrt{Y^2(t) + Y^2(t - \tfrac{1}{4F})},$$

and a second calculation device (7) for calculating the value $\theta_t$ of the phase of the rotating vector according to the formula:

$$\theta_t = \text{arc tg} \left( \frac{Y(t)}{Y(t - \tfrac{1}{4F})} \right)$$

5. Demodulation according to claim 3, the input of the sampler (3) further receiving a reference signal of the frequency F and of given amplitude, this reference signal preceding the signal to be demodulated, said demodulator performing the method of claim 2, characterized in that it comprises detection means (30) for detecting the presence of the reference signal, in that the second calculation means (31 and 32) comprise a first calculation device (31) for determination of a value $\gamma$ according to the formula: $\gamma = \theta_t - \psi_t - \phi_o$, $\phi_o$ corresponding to the phase shift of the reference signal with respect to the first carrier, this first calculating device (31) having a control input coupled to the output of the detection means, and a second calculation device (32) for calculating $\alpha$ and $\beta$ according to the formulae:

$$\alpha = \rho_t \cos \gamma \text{ and } \beta = \rho_t \sin \gamma$$

6. Demodulator for demodulation of a suppressed carrier amplitude modulated signal as obtained from two quadrature carriers of the same frequency F, characterized in that it comprises a sampler for sampling the signal to be modulated and coupled to charge transfer devices (CCD) for performing the method of any of claims 1 and 2.

7. Television system, characterized in that it comprises at least one demodulator according to any of claims 3 to 6.

## Patentansprüche

1. Verfahren zur Demodulation eines amplitudenmodulierten Signals, das aus einer durch zwei Modulationssignale und mit unterdrücktem Träger erfolgenden Amplitudenmodulation eines ersten und eines zweiten Trägers resultiert, welche dieselbe Frequenz F haben und um 90° phasenverschoben sind, wobei das zu demodulierende Signal dargestellt ist durch die auf eine Achse OX erfolgende Projektion eines um einen Punkt O in einem OXY-System rotierenden Vektors, wobei das Verfahren darin besteht, das zu demodulierende Signal mit der Frequenz mF abzutasten (m reell, positiv und grösser als 1) und die Polarkoordinaten $(\rho_t, \theta_t)$ des rotierenden Vektors mittels zwei aufeinanderfolgenden Abtastproben des zu demodulierenden Signals zu bestimmen, dadurch gekennzeichnet, dass es ferner darin besteht, die Werte $\alpha$ und $\beta$ der Amplituden der beiden Modulationssignale in Abhängigkeit von den Polarkoordinaten des rotierenden Vektors und den Zeitpunkten, zu denen das zu demodulierende Signal abgetastet wird, zu bestimmen.

2. Demodulationsverfahren nach Anspruch 1, bei welchem dem modulierten Signal ein Bezugssignal der Frequenz F und mit gegebener Amplitude vorausgeht, dadurch gekennzeichnet, dass es darin besteht, den Polarwinkel $\psi_t$ des Vektors zu bestimmen, welcher das Bezugssignal darstellt, und dass die Bestimmung der Werte der Amplituden der beiden Modulationssignale eine Funktion der Polarkoordinaten des rotierenden Vektors, der das zu demodulierende Signal darstellt, und des Wertes $\psi_t$ ist.

3. Demodulator, in dem das Verfahren nach Anspruch 1 zur Anwendung gelangt, mit: einem Abtaster (3), dessen Abtastfrequenz mF beträgt und der einen Eingang zum Empfangen des zu demodulierenden Signals aufweist; einem Analog/Digital-Umsetzer (4) zur Umsetzung der von dem Abtaster (3) ausgewählten Abtastproben; einer Verzögerungsvorrichtung (5) mit der Verzögerung $\tau = \dfrac{1}{mF}$, mit einem an den Ausgang des Umsetzers (4) angekoppelten Eingang, dadurch kegennzeichnet, dass er erste Rechenmittel (6 und 7) zur Bestimmung der Polarkoordinaten $(\rho_t, \theta_t)$ des rotierenden Vektors in Abhängigkeit von zwei aufeinanderfolgenden Abtastproben des Signals, wobei die ersten Rechenmittel (6 und 7) einen Eingang und einen zweiten Eingang aufweisen, von denen der erste an den Eingang und der zweite an den Ausgang der Verzögerungsvorrichtung (5) angekoppelt ist, und zweite Rechenmittel (31 und 32) enthält, um die Amplitudenwerte der beiden Modulationssignale in Abhängigkeit von den Polarkoordinaten des rotierenden Vektors und von den Zeitpunkten, zu denen das Signal abgetastet wird, zu bestimmen.

4. Demodulator nach Anspruch 3, dadurch gekennzeichnet, dass m gleich 4 ist, dass der Umsetzer (4) und die Verzögerungsvorrichtung (5) zu einem beliebigen Zeitpunkt t die Abtastproben Y (t) bzw. $Y (t - \dfrac{1}{4F})$ liefern und dass die ersten Rechenmittel (6 und 7) eine erste Rechenvorrichtung (6) zur Berechnung des Wertes $\rho_t$ des Betrages des rotierenden Vektors nach folgender Formel

$$\rho_t = \sqrt{Y^2(t) + Y^2(t - \frac{1}{4F})},$$

und eine zweite Rechenvorrichtung (7) zur Berechnung des Wertes $\theta_t$ für die Phase des rotierenden Vektors nach folgender Formel enthalten:

$$\theta_t = \text{arc tg} \left( \frac{Y(t)}{Y(t - \frac{1}{4F})} \right).$$

5. Demodulator nach Anspruch 3, bei welchem der Eingang des Abtasters (3) ferner ein Bezugssignal der Frequenz F und mit gegebener Amplitude empfängt, wobei dieses Bezugssignal dem zu demodulierenden Signal vorausgeht und wobei der Demodulator das Verfahren nach Anspruch 2 anwendet, dadurch gekennzeichnet, dass er Detektionsmittel (30) zur Erfassung der Anwesenheit des Bezugssignals umfasst und dass die zweiten Rechenmittel (31 und 32) eine erste Rechenvorrichtung (31) zur Bestimmung eines Wertes $\gamma$ nach folgender Formel: $\gamma = \theta_t - \psi_t - \phi_0$ enthalten, worin $\phi_0$ der Phasenverschiebung des Bezugssignals gegen den ersten Träger entspricht und wobei diese erste Rechenvorrichtung (31) einen Steuereingang aufweist, der mit dem Ausgang der Detektionsmittel verbunden ist, und eine zweite Rechenvorrichtung (32) umfasst, um $\alpha$ und $\beta$ nach folgenden Formeln zu berechnen:

$$\alpha = \rho_t \cos \gamma \text{ und } \beta = \rho_t \sin \gamma$$

6. Demodulator für ein amplitudenmoduliertes Signal zur mit Trägerunterdrückung erfolgenden Demodulation von zwei Trägern derselben Frequenz F, die um 90° phasenverschoben sind, dadurch gekennzeichnet, dass er einen Abtaster zur Abtastung des zu demodulierenden Signals umfasst, der an Ladungsverschiebevorrichtungen (CCD) angekoppelt ist, zur Durchführung des Verfahrens nach Anspruch 1 oder 2.

7. Fernsehsystem, dadurch gekennzeichnet, dass es wenigstens einen Demodulator nach einem der Ansprüche 3 bis 6 enthält.